Europäisches Patentamt

European Patent Office

Office européen des brevets

(11) Publication number: **0 067 153**
**B1**

(12) **EUROPEAN PATENT SPECIFICATION**

(45) Date of publication of patent specification: **09.10.85**

(21) Application number: **81901401.0**

(22) Date of filing: **19.12.80**

(86) International application number:
**PCT/US80/01714**

(87) International publication number:
**WO 82/02253 08.07.82 Gazette 82/17**

(51) Int. Cl.⁴: **G 01 R 33/00, H 03 F 9/00**

(54) **DUAL CORE MAGNETIC AMPLIFIER SENSOR.**

(43) Date of publication of application:
**22.12.82 Bulletin 82/51**

(45) Publication of the grant of the patent:
**09.10.85 Bulletin 85/41**

(84) Designated Contracting States:
**AT CH DE FR GB LI LU NL SE**

(56) References cited:
**CH-A- 435 447**
**DE-A-1 763 343**
**US-A-2 657 281**
**US-A-2 892 155**
**US-A-3 135 911**
**US-A-3 351 851**
**US-A-3 855 528**

(73) Proprietor: **UNITED TECHNOLOGIES CORPORATION**
**United Technologies Building 1, Financial Plaza**
**Hartford, CT 06101 (US)**

(72) Inventor: **LIPMAN, Kenneth**
**15 Rye Ridge Parkway**
**West Hartford, CT 06117 (US)**

(74) Representative: **Waxweiler, Jean et al**
**OFFICE DENNEMEYER S.à.r.l. 21-25 Allée**
**Scheffer P.O.Box 41**
**L-2010 Luxembourg (LU)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to current measuring devices and, more particularly to a circuit for measuring the magnitude and polarity of a DC current flowing in a line.

Many different types of devices for measuring DC electric current are known and one such device is a magnetic amplifier which is typically used where the DC current being measured is at a high voltage level making it desirable to electrically isolate the measuring instruments from the potentially dangerous effects of the high voltage. Magnetic amplifier sensors typically utilize a plurality of saturable reactors, which may include a saturable core on which the conductor is wound that carries the DC current to be measured. These saturable reactors may influence the bias voltage from a source of AC source by an amount proportional to the measured current. Finally, an indicating device, such as a meter or the like, provides a readable indicia of the measured DC current.

One such device, disclosed in U.S. Patent No. 3,855,528 issued to H. Brown on December 17, 1974 entitled DC CURRENT MEASURING CIRCUIT, is a measuring circuit for indicating the magnitude of DC current flow through a conductor which includes a voltage generating circuit for creating chopped DC voltages and a magnetic amplifier with two saturable cores. The current to be measured is passed through the command winding to control the current which the voltage generating circuit applies to the control winding. The measuring circuit exhibits a plurality of equilibrium conditions in each of which the magnitude of the control current flow is determined by the magnitude of the input current, thus causing the control current flow to be a continuous DC output indication of DC input current.

A related measuring device is disclosed in U.S. Patent No. 3,135,911 issued June 2, 1964 to R. Van Allen entitled POLARITY SENSITIVE SATURABLE CORE REACTOR. This measuring circuitry includes a saturable reactor having two cores, and a polarity sensing circuit inductively coupled to the saturable reactor to produce a unidirectional signal responsive to the direction of the measured current which is in turn used as a control winding of the saturable reactor.

Still another similar apparatus is disclosed in U.S. Patent No. 2,892,155 issued June 23, 1959 to R. Radas et al entitled APPARATUS RESPONSIVE TO DIRECT QUANTITIES. The Radas et al device is concerned with correcting the non-linear condition that occurs within the range of relatively small values of measured current so that for a zero value of the energizing quantity, there is produced an output quantity having a zero value. A transformer essentially acts as a bias winding and one coil links the cores of the magnetic amplifier. The bias winding is effective when energized to render the cores responsive to the polarity of the energizing quantity to thereby render the measuring instrument responsive to both the magnitude and direction of the energy quantity.

Of interest is a discussion of high-speed reset magnetic amplifiers on page 54 of "Tape Wound Core Design Manual" issued by Magnetic Metals Company of Camden, New Jersey (no date). A self-saturating type of magnetic amplifier is disclosed in which AC power causes the magnetic core to saturate and a rectified waveform appears across a load. The AC voltage resets the cores flux level every half cycle so that there is a new flux level from which the gate circuit will start on the next cycle. A differential output type for high stability type operation to actuate hydraulic valves or other differentially operating devices.

The prior art magnetic amplifier type of current sensing device which provides both a magnetic and polarity indication at the output typically required three or more coils on a saturable core or, if only two coils on each core were used, an elaborate bias adjustment circuit is needed to compensate for variations in temperature and AC source voltage driving the cores that would otherwise distort the output linearity.

It is an object of the present invention to provide a magnetic amplifier sensor for measuring the magnitude and polarity of a high voltage DC current with a saturable core technique employing a minimal number of coils.

Another object of the present invention is to provide a DC current measuring device with a minimal number of component parts which is suitable for measuring high voltage DC electric current and providing an output signal indicating the magnitude and polarity of the measured current in an environment which may be subject to temperature and voltage variations.

According to the present invention, a magnetic amplifier sensor includes a pair of saturable cores, the flux level of which is drivable from an unsaturated state to a saturated state in response to a magnetomotive force in one direction and resettable from the saturated state to an unsaturated state by a magnetomotive force in the opposite direction;

shunt means responsive to said main current for generating a shunt current proportional to said main current to create a magnetomotive force which changes the flux level in each of said saturable cores in one direction;

voltage means for creating a drive magnetomotive force and a reset magnetomotive force within each of said pair of saturable cores for driving the respective flux levels of each core in opposite directions to a saturation point, and for resetting the respective flux levels within each of said saturable cores to a lower level;

bias means connected to said voltage means for initially calibrating the respective flux levels in each of said cores; and

output means for sensing the polarity of, and the time deviation of, the difference between the points at which the flux levels in each of said cores reaches the saturation point, and for providing an output signal which is proportional to this deviation and also to said main current.

The invention is set out in the claims 1 to 5, to which reference should now be made.

Other objects, features and advantages of the present invention will become apparent in light of the following detailed description of a preferred embodiment as illustrated in the accompanying drawing.

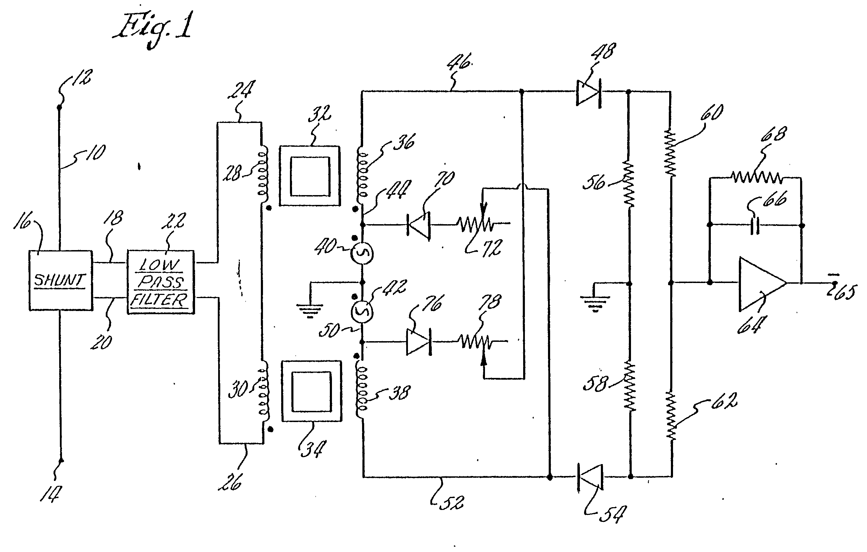

Referring initially to Fig. 1, there is seen a first embodiment of a magnetic amplifier sensor according to the present invention which is used to measure the magnitude and direction of a DC current flowing in a line 10 from a terminal 12 to a terminal 14. The line 10 may carry output electrical energy from a device such as a converter (not shown) or other types of machine to an electrical power-consuming or producing device (not shown) and this electrical energy may be at a voltage level of up to several thousand volts with a current level of from zero to hundreds or even thousands of amperes. One type of converter is an inverter which converts DC electrical energy to AC electrical energy but the output from an inverter typically includes both a DC current component and an AC current component and it is often necessary to precisely measure the DC current component in order to control the inverter itself.

To this end, a conventional shunt 16 is connected in line 10 in a series relationship such that all of the current between terminals 12 and 14 passes therethrough. The shunt 16 includes a pair of secondary terminals to which lines 18 and 20 are connected and a small amount of current is diverted from line 10 through this shunt circuit, this diverted current being of a known proportional relationship to the current in the line 10.

A low pass filter 22 is connected in the shunt circuit in the lines 18 and 20 for removing any AC component of the current diverted from the current in the line 10. The DC component of the shunted current is fed from the low pass filter 22, via the lines 24 and 26, to a pair of series-connected primary windings 28 and 30. A first saturable core 32 and a second saturable core 34 are provided and the windings 28 and 30 are mounted on the first and second saturable cores, respectively. It is important to note the directional orientation of each of the windings 28 and 30 on the respective cores (indicated by the dots in Fig. 1) in that the proportional DC current diverted from the line 10 into the shunt circuit creates a magnetomotive force of flux field in the core in one direction, (e.g. clockwise in the drawing), in response to a DC current flowing in a first direction in the line 10 from the terminal 12 to the terminal 14. However, a flux field is created in the opposite direction (e.g. counterclockwise in Fig. 1) in each core in response to a DC current flowing in an opposite direction in the line 10 from the terminal 14 to the terminal 12. Also mounted on the core 32 and the core 34 are secondary windings 36 and 38, respectively. The primary winding 28 on the first saturable core 32 is wound in a differential relationship with the secondary winding 36 so that a current in one direction (i.e. into the dots) establishes flux fields that oppose each other. However, the primary winding 30 and the secondary winding 38 positioned on the second saturable core 34 are wound in such a manner that a current therethrough in one direction (i.e. into the dots) creates respective flux fields which reinforce or add. The conductors making up each of the windings are insulated to provide electrical isolation between the individual coils of each winding and also between the primary and secondary windings themselves. Electrical isolation is particularly important between the primary and secondary windings on each saturable core because the output current of an inverter may be at a voltage potential in the kilovolt range while the circuit components that include the secondary windings are designed to operate at very low voltages and would be severely damaged if subjected to the high primary voltage potentials.

The magnetic amplifier sensor of the present invention includes an AC source such as a transformer with its center tap grounded so that it appears as an in-phase pair of AC sources 40 and 42, connected in series with the innerconnection grounded. The frequency of operation of the AC sources 40 and 42 is selected to be sufficiently high such that during one cycle of operation for which the set and reset period of the saturable cores occurs, the magnitude of the DC level to be measured is relatively constant. The AC source 40 is connected via a line 44 to the secondary winding 36 on the first saturable core 32 and, in turn, by a line 46 to the anode side of a diode 48. In a similar manner, the AC source 42 is connected by a line 50 to the secondary winding 38 on the second saturable core 34 and, via a line 52, to the cathode side of a diode 54. A resistor 56 is connected between the cathode side of the diode 48 and ground while a resistor 58 is connected between the anode side of the diode 54 and ground. The differential voltage across the two resistors 56 and 58 is fed via a pair of resistors 60 and 62 to an integration circuit comprised of a high gain operational amplifier 64 with its input end connected to the resistors 60 and 62. A capacitor 66 and a resistor 68 shunt the input and the output terminal 65 of the amplifier 64 to create an integration circuit.

The magnetic amplifier sensor of the present invention includes a bias circuit for initially calibrating the component parts whose conducting state may vary slightly in response to temperature, shock or other such variations. The calibration circuit includes a diode 70 which has its cathode terminal coupled to the line 44 between the AC source 40 and the secondary winding 36 on the first saturable core 32. A potentiometer 72 is connected between the anode terminal of the diode 70 and the line 52. In a similar manner, the other half of the circuit comprises a diode 74 having its anode terminal coupled to the line 50 which connects the voltage source 42 to the secondary winding 38 on the second saturable core 34. A potentiometer 78 connects the cathode end of the diode 76 to the line 46. The bias circuit allows the two cores to be operated with flux level settings along the middle portion of the BH curve which is the most linear portion of the curve. Any drift in this initial calibration, such as would result from temperature variations, etc. affect both cores equally such that the differential operation of the magnet amplifier results in no effect at the output.

To calibrate the magnetic amplifier sensor of the present invention, the shunt circuit diverting current from the line 10 is opened so that no current flows through the primary windings 28 and 30 on the saturable cores. An oscilloscope is connected across one winding and the respective potentiometer balance varied until saturation occurs at approximately 90°. With the other core balance to this point, the output voltage will be zero.

The operation of the dual core magnetic amplifier sensor according to the present invention will now be described. The magnetic amplifier sensor is of the reset type which has the advantage of overcoming the typically slow response inherent in a self-saturating device employing magnetic cores. The reset type of magnetic amplifier generally includes a first interval known as the drive interval when the cores are driven toward saturation and a second period known as the reset interval when the level of flux in the magnetic cores is driven back or reset to a lower point on the well known BH curve.

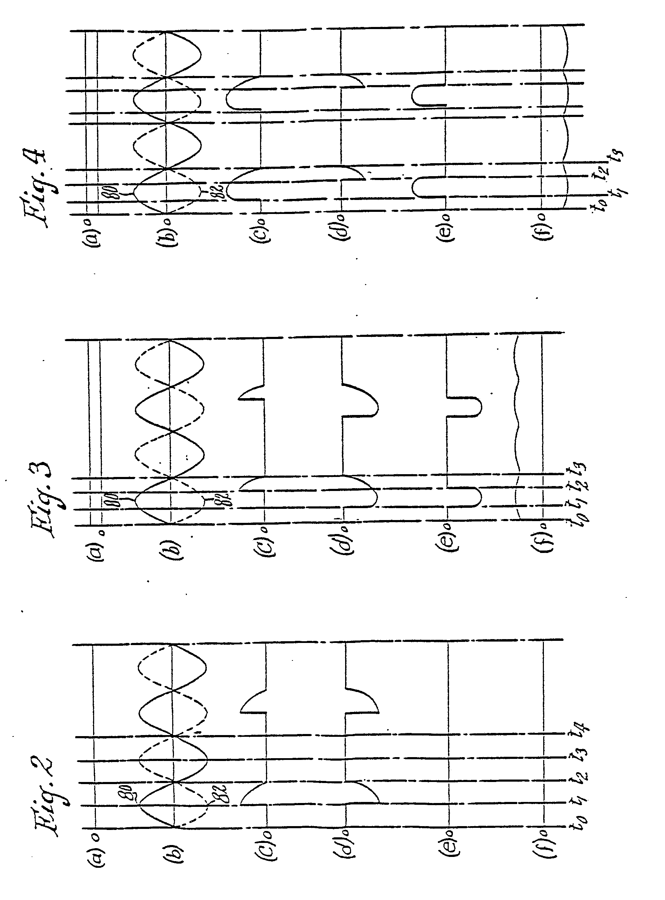

Referring now to Fig. 2, illustration (a) represents the magnitude of the DC current diverted into the shunt circuit so that it passes through the primary windings 28 and 30. As is seen, the magnitude of the DC current is essentially zero so that there is no flux level within either the first saturable core 32 or the second saturable core 34 resulting from a DC current in these primary windings. Next, referring to illustration (b) of Fig. 2, a representation of the source voltage is seen and the voltage output of the AC source 40 is illustrated by waveform 80 while the voltage output of the AC source 42 is illustrated by waveform 82. The drive interval of the magnetic amplifier sensor from $t_0$ to $t_2$ or during a first half cycle of the source voltage while the reset interval occurs during the last half cycle or from $t_2$ to $t_4$. When no DC component of the current is passed through the primary windings, both cores saturate essentially simultaneously during the drive period at $t_1$ because there is no longer a flux change within each core and the voltage across the secondary windings drops to zero and the source voltages appear at the output end of the diodes. At this point $t_1$, the combined voltage of the sources 40 and 42 is impressed across the resistors 56 and 58, the voltage waveform across the resistor 56 being shown in illustration (c) of Fig. 2 while the voltage waveform across the resistor 58 being shown in illustration (d) of Fig. 2, but because of the differential nature of the voltage, i.e. one is at a positive maximum while the other is at a negative maximum, the voltage waveforms cancel and the combined waveform is zero as seen in illustration (e) of Fig. 2. This voltage is presented to the input of the operational amplifier which acts as an integration circuit and no waveform appears at the output of the magnetic amplifier sensor, terminal 65. At $t_2$, the reset interval begins and the respective voltage sources cause a reverse current to flow in the secondary winding and the resulting current drives or resets the flux level in each of the saturable cores 32 and 34 from their respective maximum points on the well known BH magnetic curve so that by $t_4$ the cores are ready for the next drive interval. Accordingly, there is no output from the magnetic amplifier at terminal 62 as is seen in illustration (f) of Fig. 2.

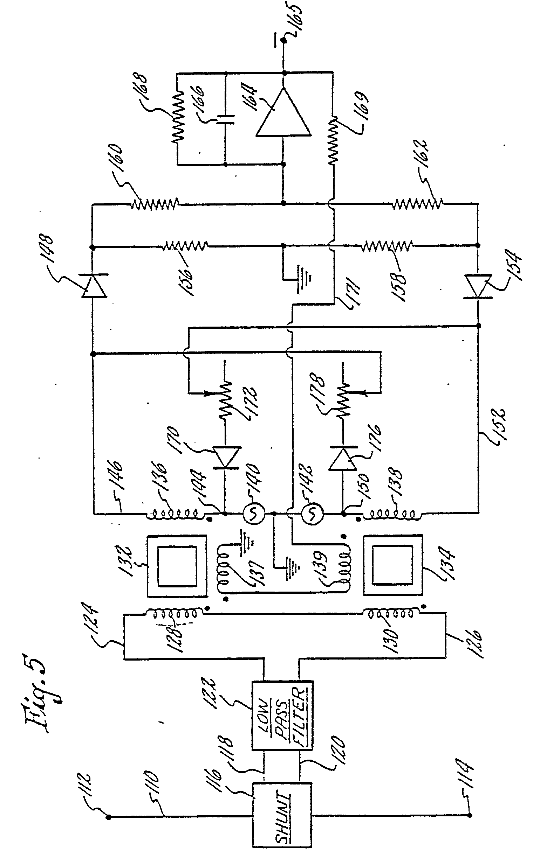

Referring next to Fig. 3, the operation of the magnetic amplifier circuit according to the present invention will now be described when there is a DC component of current diverted from the line 10 into the shunt current so that it passes in series through the primary windings 28 and 30, the current level in the shunt circuit being shown in illustration (a) of Fig. 3. As before, illustration (b) of Fig. 3 is a representation of the source voltage waveform and the voltage output of the AC source 40 is represented by the waveform 80 while the voltage output of the AC source 42 is shown by the waveform 82. During the drive interval, $t_0$ to $t_3$, the AC sources drive the flux levels in the respective cores toward their saturation point. But because of the absolute value of the flux level in the two cores is not identical due to the shunt current, the core 34 saturates first, as is seen in illustration (d) of Fig. 3 at $t_1$, causing the source voltage 42 to then appear across the resistor 56. Because the flux level is still increasing in the saturable core 32, no corresponding voltage appears across the resistor 56 at this time, as is seen in illustration (c) of Fig. 3. Finally, the flux level in the core 32 reaches its saturation point, illustration (c) of Fig. 3 at $t_2$, and the AC source voltage 44 now appears across the resistor 58. Accordingly, the combined differential voltage across the two resistors 56 and 58 is presented to the input of the integration amplifier, as shown in illustration (e) of Fig. 3. As will be appreciated by those of ordinary skill, the integration of this waveform will result in a signal at the output terminal 65 whose magnitude is directly proportional to the difference in saturation times of the two cores, or $t_1$ to $t_2$, while having a polarity in one direction, this being shown in illustration (f) of Fig. 3. It can be noted that there is a slight ripple on the output waveform which varies in magnitude with the selection of the circuit components as is well known.

Referring next to Fig. 4, the operation of the magnetic amplifier circuit according to the present invention will now be described when there is a DC component of current diverted from the line 10 into the shunt current so that it passes in series through the primary windings 28 and 30 in a reverse direction with respect to the illustrations of Fig. 3. In the same manner as before, the current level in the shunt circuit is shown in illustration (a) of Fig. 4 while illustration (b) of Fig. 4 is the source voltage waveforms of the AC source 40, shown as the waveform 80, and the AC source 42, shown as the waveform 82. During the drive interval, $t_0$ to $t_3$, the AC sources drive the flux levels in the respective cores toward their saturation point. But because of the absolute value of the flux levels in the cores is not identical due to the shunt current, the core 32 saturates first, as is seen in illustration (c) of Fig. 3 at $t_1$, causing the source voltage 44 to appear across the resistor 58. Because the flux level is still increasing in the saturable core 34, no corresponding voltage appears across the resistor 58 at this time, as is seen in illustration (d) of Fig. 3. Finally, the flux level in the core 34 reaches its saturation point, illustration (d) in Fig. 3 at $t_2$, and the AC source voltage 42 appears across the resistor 56. Accordingly, the combined differential voltage across the two resistors 56 and 58 is presented to the input of the integration amplifier, illustration (e) of Fig. 3. As will be appreciated by a comparison of the output waveform, illustration (f) of Fig. 4, the integration of this waveform will result in a signal whose magnitude is directly proportional to the difference in the saturation times between the two cores, or $t_1$ to $t_2$, while having a polarity in a direction opposite to that shown in illustration (f) of Fig. 3.

Referring now to Fig. 5, there is seen a second embodiment of the magnetic amplifier sensor according to the present invention, this embodiment being well suited to measure both AC and DC currents due to its use of negative feedback. A conventional shunt 116 is connected in a line 110 in a series relationship such that all of the current passing between terminals 112 and 114 pass therethrough. The shunt 116 includes a pair of secondary terminals to which lines 118 and 120 are connected and a small amount of current is diverted from the line 110 through this shunt path, this diverted current being of a known proportional relationship to the current in the line 110. A low pass filter 122 is connected in the shunt circuit in lines 118 and 120 for removing any AC component of the current diverted from the larger current in the line 110. However, the low pass filter 122 can be smaller than the filter used in conjunction with the embodiment of Fig. 1 which increases response time, as will be described in greater detail hereinafter.

The shunted current is fed from the low pass filter 122 via lines 124 and 126 to a pair of series-connected primary windings 128 and 130. A first saturable core 132 and a second saturable core 134 are provided and the windings 128 and 130 are mounted on the first and and second saturable cores, respectively. It is important to note the directional orientation of each of the windings 128 and 130 on the respective cores (indicated by the dots in Fig. 5) in that the proportional current diverted from the line 110 into the shunt circuit creates a magnetomotive force or flux field in the core in one direction (e.g. clockwise in the drawing), in response to a current flowing in the line 110 from the terminal 112 to the terminal 114. However, a flux field is created in the opposite direction (e.g. counterclockwise in Fig. 5) in each core in response to a current flowing in the line 110 from the terminal 114 to the terminal 112. Also mounted on the core 132 and the core 134 are secondary windings 136 and 138, respectively.

In this second embodiment of a magnetic amplifier sensor according to the present invention, a third winding 137 is mounted on the core 132 and a third winding 139 is mounted on the core 134 to provide negative feedback. Each of these third windings are wound on their respective cores so that they establish a flux field that opposes that created in the core by the primary windings. In other words, a current through the primary winding 128 and through the third winding 137 in one direction (i.e. into the dots) establishes flux fields that oppose each other, the same being true for the primary winding 130 and the third winding 139 on the core 134. As before, the primary winding 128 on the first saturable core is wound in a differential relationship with the secondary winding 136 while the primary winding 130 and the secondary winding 138 are wound in such a manner that a current therethrough creates flux fields which reinforce or add. The conductors making up all three windings on each core are insulated to provide electrical isolation between each winding and also between the individual coils of the windings themselves. Electrical isolation is important because the current in the line 110 may be at a voltage potential in the kilovolt range or even higher if an AC device is involved while the circuit components that include the secondary and tertiary windings are designed to operate at very low voltages and would be severely damaged if subjected to the high primary voltage potentials.

As before, the magnetic amplifier sensor of the present invention includes an AC source with its center tap grounded so that it appears as an in-phase pair of AC sources 140 and 142 connected in series with the innerconnection grounded. The frequency of operation of the AC sources 140 and 142 is selected to be sufficiently high such that during one cycle of operation for which the set and reset period of the saturable cores occur, the magnitude of the level of current to be measured can be considered relatively constant, this being true even if the magnitude of an AC current is being measured because of rapid response time of this circuit configuration. The AC source 140 is connected, via a line 144, to the secondary winding 136 on the first saturable core 132 and, in turn by a line 146, to the anode side of a diode 148. In a similar manner, the AC source 142 is connected by a line 150 to the secondary winding 138 on the second saturable core 134 and, via a line 152, to the cathode side of a diode 154. A resistor 156 is connected between the cathode side of the diode 148 and ground while a resistor 158 is connected between the anode side of the diode 154 and ground. The differential voltage across the two resistors 156 and 158 is fed via resistors 160 and 162 to an integration circuit comprised of a high gain operational amplifier 164 coupled with its input connected to the resistors 160 and 162. A capacitor 166 and a resistor 168 shunt the input and output terminals of the amplifier 164 creating an integration circuit.

A feedback circuit of this second embodiment of the magnetic amplifier sensor includes a resistor 169 coupled to the output terminal 165 of the operational amplifier 164 for feeding back a portion of the output signal. A line 171 is connected to one side of the third winding on the core 134. The other end of the third winding 134 is connected to one side of the winding 137 on the core 132, which has its opposite end grounded.

As before, a calibration circuit is provided for initially balancing the two halves of the circuit to compensate for any component parts whose conducting states may have varied slightly in response to temperature, shock or other such stresses. An additional advantage of this second embodiment is that due to the negative feedback provided through the tertiary windings, the calibration of the magnetic amplifier sensor is less critical. The calibration circuit includes a diode 170 which has its cathode terminal coupled to the line 144 between the AC source 140 and the secondary winding 136 on the first saturable core 132. A potentiometer 172 is connected between the anode terminal of the diode 170 and the line 152. In a similar manner, the other half of the circuit comprises a diode 174 having its anode terminal coupled to the line 150 which connects the voltage source 142 to the secondary winding 138 on the second saturable core 134. A potentiometer 178 connects the cathode end of the diode 176 to the line 146.

To calibrate the magnetic amplifier sensor, the shunt circuit diverting current from the line 110 is open so that no current flows through either of the primary windings on the saturable cores 132 and 134. Without a flux induced in the saturable cores, the potentiometers 172 and 178 can be adjusted until the output voltage at the terminal 165 is balanced to zero.

The operation of this second embodiment of the dual core magnetic amplifier sensor according to the present invention can be best understood by referring to the heretofore described operation of the first embodiment. The written description of the operation of the first embodiment together with waveform illustrations in Figs. 2—4 are equally applicable to this second embodiment. The feedback circuit presents a portion of the output signal appearing at the output terminal 165 through resistor 169 to the series-connected third windings on the saturable cores 132 and 134 which causes each of the saturable cores to operate on a shorter, and hence more linear, portion of the well known BH curve. Resistor 169 is usually chosen to be large enough to insure that the feedback current will be proportional to the voltage at terminal 165. As is known, negative feedback increases the response time of a circuit configuration at the expense of low circuit gain making this second embodiment particularly well suited for measuring the magnitude and polarity of a current which varies over a relatively short period of time, such as an AC current. Accordingly, this second embodiment can operate as an isolated measuring instrument for sensing either an AC or DC current in satisfying the environmental constraints of a number of measuring and testing requirements. Of course, the specific value of the circuit components shown in either the first or second embodiment would vary depending on the desired response times, current levels to be measured, etc. and the retention of these values would be within the skill of an artisan.

## Claims

1. A magnetic amplifier for sensing the magnitude and polarity of a main current (10), comprising:
a pair of saturable cores (32, 34), the flux level of which is drivable from an unsaturated state to a saturated state in response to a magnetomotive force in one direction and resettable from the saturated state to an unsaturated state by a magnetomotive force in the opposite direction; and
shunt means (16) responsive to said main current (10) for generating a shunt current proportional to said main current to create a magnetomotive force which changes the flux level in each of said saturable cores (32, 34) in one direction; characterized by
voltage means (40, 42) for creating a drive magnetomotive force and a reset magnetomotive force within each of said pair of saturable cores (32, 34) for driving the respective flux levels of each core in opposite directions to a saturation point, and for resetting the respective flux levels within each of said saturable cores to a lower level;
bias means (70, 72; 76, 78) connected to said voltage means (40, 42) for initially calibrating the respective flux levels in each of said cores (32, 34); and
output means (56, 58, 60, 62) for sensing the polarity of, and the time deviation of, the difference between the points at which the flux levels in each of said cores (32, 34) reaches the saturation point, and for providing an output signal which is proportional to this deviation and also to said main current (10).

2. A magnetic amplifier according to claim 1, wherein said shunt means (16) is connected to receive said main current therethrough, diverts a portion of said main current into a shunt circuit (18—22), and wherein a primary winding (28, 30) disposed on each of said pairs of saturable cores receives said shunt current therethrough.

3. A magnetic amplifier according to claim 2, further including a secondary winding (36, 38) disposed on each of said saturable core means (32, 34), and wherein said voltage means (40, 42) is connected to each of said secondary windings (36, 38) for creating a drive magnetomotive force and a reset magnetomotive force with each saturable core (32, 34), and wherein said output means (56, 58, 60, 62) further includes a diode means (48, 54) connected to each of said secondary windings (36, 38) for providing a differential voltage proportional to the deviation between the saturation points in each core (32, 34).

4. A magnetic amplifier according to claim 3, further including an integration means (64, 66, 68) connected to said diode means for integrating the differential voltage thereacross to provide an output signal which is proportional to the main current (10).

5. A magnetic amplifier according to claim 4, further including on each of said cores (132, 134) a third winding (137, 139), said third windings (137, 139) being connected in series to the output of said output integration means (164—168).

**Revendications**

1. Transducteur pour mesurer l'amplitude et la polarité d'un courant principal (10), comprenant une paire de noyaux (32, 34) pouvant être saturés, dont le niveau de flux est excité d'un état non-saturé vers un état saturé en réponse à une force magnétomotrice dans une direction et remis de l'état saturé vers un état non-saturé par une force magnétomotrice de direction opposée et un moyen shunt (16) répondant au courant principal (10) pour produire un courant parallèle proportionnel au courant principal pour créer une force magnétomotrice qui change dans une direction le niveau de flux dans chacun des noyaux (32, 34) pouvant être saturés, caractérisé par un moyen de tension (40, 42) pour créer une force magnétomotrice d'excitation et une force magnétomotrice de remise dans chacun de la paire de noyaux (32, 34) pouvant être saturés pour exciter les niveaux de flux respectifs dans chaque noyau dans des directions opposées vers un point de saturation et pour remettre les niveaux de flux respectifs dans chacun des noyaux pouvant être saturés vers un niveau plus bas; des moyens de polarisation (70, 72; 76, 78) connectés audit moyen de tension (40, 42) pour calibrer initialement les niveaux de flux respectifs dans chacun des noyaux (32, 34); et un moyen de sortie (56, 58, 60, 62) pour mesurer la polarité et la déviation dans le temps de la différence entre les points auxquels les niveaux de flux dans chacun des noyaux (32, 34) atteignent le point de saturation et pour fournir un signal de sortie qui est proportionnel à cette déviation et donc au courant principal (10).

2. Transducteur selon la revendication 1, dans lequel le moyen shunt (16) est connecté pour recevoir le courant principal à travers lui, dévie une partie du courant principal dans un circuit shunt (18—22) et dans lequel un enroulement primaire (28, 30), disposé sur chacun de la paire de noyaux pouvant être saturés, reçoit le courant parallèle.

3. Transducteur selon la revendication 2, comprenant en outre un enroulement secondaire (36, 38) disposé sur chacun de la paire de noyaux (32, 34) et dans lequel le moyen de tension (40, 42) est connecté à chacun des enroulements secondaires (36, 38) pour créer une force magnétomotrice d'excitation et une force magnétomotrice de remise dans chacun des noyaux (32, 34) pouvant être saturés et dans lequel le moyen de sortie (56, 58, 60, 62) comprend en outre une diode (48, 54) connectée à chacun des enroulements secondaires (36, 38) pour fournir une tension différentielle proportionnelle à la déviation entre les points de saturation dans chaque noyau (32, 34).

4. Transducteur selon la revendication 3, comprenant en outre un moyen d'intégration (64, 66, 68) connecté à la diode pour intégrer la tension différentielle pour fournir un signal de sortie qui est proportionnel au courant principal (10).

5. Transducteur selon la revendication 4, comprenant en outre sur chacun des noyaux (132, 134) un troisième enroulement (137, 138), lesdits troisièmes enroulements (137, 139) étant connectés en séries à la sortie du moyen intégrateur (164—168).

**Patentansprüche**

1. Magnetverstärker zum Messen der Amplitude und Polarität eines Hauptstromes (10), mit einem Paar sättigbarer Kerne (32, 34), deren Flussniveau von einem ungesättigten Zustand in einen gesättigten Zustand als Folge einer magnetomotorischen Kraft in einer Richtung treibbar ist und von dem gesättigten Zustand in einen ungesättigten Zustand zurücksetzbar ist, durch eine magnetomotorische Kraft in der entgegengesetzten Richtung, und eine Paralleleinrichtung (16), welche auf den Hauptstrom (10) anspricht, um einen Parallelstrom proportional zum Hauptstrom zu erzeugen, um eine magnetomotorische Kraft zu bewirken, welche das Flussniveau in jedem der sättigbaren Kerne (32, 34) in einer Richtung ändert, gekennzeichnet durch eine Spannungseinrichtung (40, 42) zum Erzeugen einer magnetomotorischen Treibkraft und einer magnetomotorischen Rücksetzkraft in jedem des Paares sättigbarer Kerne (32, 34), um die jeweiligen Flussniveaus in jedem Kern in entgegengesetzte Richtungen zu treiben zu einem Sättigungspunkt, und um die jeweiligen Flussniveaus in jedem der sättigbaren Kerne auf ein niedrigeres Niveau zurückzusetzen, Vorspannmittel (70, 72; 76, 78), welche mit der Spannungseinrichtung (40, 42) verbunden sind, um die jeweiligen Flussniveaus in jedem der Kerne (32, 34) anfangs zu eichen und eine Ausgangseinrichtung (56, 58, 60, 62), um die Polarität und die zeitliche Abweichung der Differenz zwischen den Punkten bei denen die Flussniveaus in jedem der sättigbaren Kerne (32, 34) den Sättigungspunkt erreichen, zu messen und, um ein Ausgangssignal bereitzustellen, welches proportional zu dieser Abweichung und somit zu dem Hauptstrom (10) ist.

2. Magnetverstärker nach Anspruch 1, bei welchem der Parallelkreis (16) angeschlossen ist, um den Hauptstrom durch sich aufzunehmen, einen Teil des Hauptstromes in den Parallelkreis (18—22) abzweigt und bei dem eine Primärwicklung (28, 30) auf jedem der beiden sättigbaren Kerne angeordnet ist, um vom Parallelstrom durchflossen zu werden.

3. Magnetverstärker nach Anspruch 2, mit desweiteren einer Sekundärwicklung (36, 38), welche auf jedem der sättigbaren Kerne (32, 34) angeordnet ist, und bei dem die Spannungseinrichtung (40, 42) an jede der Sekundärwicklungen (36, 38) angeschlossen ist, um eine magnetomotorische Treibkraft und eine magnetomotorische Rücksetzkraft in jedem der sättigbaren Kerne (32, 34) zu erzeugen, und bei dem die Ausgangseinrichtung (56, 58, 60, 62) desweiteren eine Diode (48, 50) hat, welche an jede der Sekundärwicklungen (36, 38) angeschlossen ist, um eine Differenzialspannung proportional zu der Abweichung zwischen den Sättigungspunkten in jedem Kern (32, 34) zu liefern.

4. Magnetverstärker nach Anspruch 3, mit zusätzlich einer Integrationseinrichtung (64, 66, 68), welche an die Diode angeschlossen ist, um die Differenzialspannung an ihr zu integrieren, um ein Ausgangssignal bereitzustellen, welches proportional zum Hauptstrom (10) ist.

5. Magnetverstärker nach Anspruch 4, mit zusätzlich einer dritten Wicklung (137, 139) auf jedem der drei Kerne (132, 134), wobei die dritten Wicklungen (137, 139) in Reihe zu dem Ausgang der Integrationseinrichtung (164—169) angeschlossen sind.

Fig. 1

Fig. 2

Fig. 3

Fig. 4

0 067 153

Fig.5